# EUROPEAN PATENT APPLICATION

(11) **EP 4 761 145 A1**
(43) Date of publication of application: **17.06.2026**
(21) Application number: 24854382.9
(22) Date of filing: 07.08.2024
(51) Int. Cl.: H04B 10/70, G02B 5/00, B82Y 20/00, B82Y 10/00

(54) **SINGLE-PHOTON LIGHT SOURCE**

(30) Priority: 11.08.2023 KR 20230105447
(71) Applicant: Bright Quantum Inc., Daejeon 34134 (KR)
(72) Inventor: LEE, Donghan, Daejeon 34130 (KR); JANG, Yudong, Daejeon 34061 (KR); KIM, Minjun, Andong-si Gyeongsangbuk-do 36638 (KR)
(74) Representative: Appleyard Lees IP LLP
(86) International application number: PCT/KR2024/011654
(87) International publication number: WO 2025/037830

(57) **Abstract**

The present invention relates to a single photon light source capable of generating single photons with a high repetition rate and a high collection efficiency by positioning an emitter in a nanogap of a nano-antenna including a metal nanoparticle and a metal layer, and by controlling Purcell enhancement in the nanogap.

The single photon light source of the present invention is easy to manufacture with low manufacturing costs due to its simple structure and has excellent light collection efficiency by emitting single photons vertically upward through an optical antenna structure of a nano-antenna. In addition, single photons may be generated by applying various emitters to a nano-antenna, a high production yield is obtained due to the wide bandwidth, and operation may be possible at room temperature at various wavelengths.

## Description

### Technical Field

The present invention relates to a single photon light source, and more particularly to a single photon light source capable of generating single photons with a high repetition rate and a high collection efficiency by positioning an emitter in a nanogap of a nano-antenna including a metal nanoparticle and a metal layer and by controlling Purcell enhancement in the nanogap.

### Background Art

In recent years, research on quantum information technologies, including quantum cryptography communication and quantum computers, has been actively conducted worldwide.

In China, independent satellites for quantum communication has been launched and quantum cryptography communication using the satellite has been successfully demonstrated, and a nationwide transmission network for quantum cryptography communication is also being built.

In Europe, the Quantum Technology Flagship program has been carried out for ten years starting in 2018, and in the United States large-scale new research programs such as the National Quantum Initiative have been promoted in addition to existing research efforts.

In Korea, quantum cryptography communication research has also been conducted, and a national long-distance test transmission network has been established; however, because a desirable single-photon source is not available, the transmission rate is low and reliability for long-distance transmission is not guaranteed, and many aspects still need to be improved.

For application to real systems, a deterministic single-photon source with suitable performance is required, but there is still no single-photon source with practical feasibility, which makes it difficult to build and test systems.

### Disclosure of Invention

### Technical Problem

The present invention has been conceived to solve the problems described above, and an object of the present invention is to provide a single photon light source capable of generating single photons with a high repetition rate and a high collection efficiency by positioning an emitter in a nanogap of a nano-antenna including a metal nanoparticle and a metal layer and by controlling Purcell enhancement in the nanogap.

### Solution to Problem

According to an example of the present invention, a single photon light source may include: a nano-antenna including a metal layer formed on a substrate and a metal nanoparticle disposed to be spaced apart from the metal layer; and a single emitter positioned in a nanogap between the metal nanoparticle and the metal layer. The single photon light source may be configured such that when light is irradiated onto the emitter, a single photon is generated and emitted through the nano-antenna.

At least one of the size of the metal nanoparticle and the spacing of the nanogap may be adjusted to control Purcell enhancement.

The emitter may be excited to generate linearly polarized single photons.

The size of the emitter may be equal to or smaller than the spacing of the nanogap.

The nano-antenna may have a structure in which: a first metal layer is formed on the substrate; a second metal layer having a hole at a center thereof is formed on the first metal layer; and the metal nanoparticle is disposed above the first metal layer and inside the hole of the second metal layer. In this case, the emitter may be positioned in a nanogap between the metal nanoparticle and an inner wall surface of the hole of the second metal layer.

The nano-antenna may have a structure in which: a second metal layer having a hole at a center thereof is formed on the substrate; and the metal nanoparticle is disposed above the substrate and inside the hole of the second metal layer. In this case, the emitter may be positioned in a nanogap between the metal nanoparticle and an inner wall surface of the hole of the second metal layer.

The nano-antenna may have a structure in which: a first metal layer is formed on the substrate; and the metal nanoparticle is disposed above the first metal layer. In this case, the emitter may be positioned in a nanogap between the metal nanoparticle and an upper surface of the first metal layer.

The spacing of the nanogap may be configured to become narrower from an upper side toward a lower side, or to become narrower from an outer side toward an inner side.

The emitter may have a spherical shape.

The emitter may have a plate shape.

The emitter may include, a single colloidal quantum dot, a core/shell quantum dot, a diamond defect structure, a silicon defect structure, a two-dimensional semiconductor defect structure, or a nanoplatelet structure.

The metal nano-particle may have a spherical shape.

The metal nano-particle may have a cut spherical shape.

The metal nano-particle may have a cylindrical or polyhedral shape.

The single photon light source may further include a support portion supporting the metal nanoparticle, and the metal nanoparticle may be seated on the support portion.

The single photon light source may further include a lens surrounding the metal nanoparticle, and the lens may collect single photons emitted from the metal nanoparticle in a vertically upward direction.

At least a portion of a surface of the nano-antenna may be provided with a coating layer.

The nano-antenna may include a first metal layer formed on the substrate, an insulating layer formed on the first metal layer and a second metal layer having a hole at a center thereof formed on the insulating layer; the metal nanoparticle disposed above the insulating layer and inside the hole of the second metal layer, and the emitter positioned in a nanogap between the metal nanoparticle and an inner wall surface of the hole of the second metal layer.

### Advantageous Effects of Invention

The single photon light source of the present invention has a simple structure, thereby facilitating manufacture and reducing manufacturing cost, and has an advantage of excellent collection efficiency by emitting single photons vertically upward through the optical antenna structure of the nano-antenna.

In addition, single photons can be generated by applying various emitters to the nano-antenna, and because the bandwidth is wide, the production yield is high and operation is possible at room temperature and at various wavelengths.

### Brief Description of Drawings

FIG. 1 is a diagram for explaining target performance of the single photon light source of the present disclosure.
FIG. 2 is a diagram illustrating a single photon light source according to an example of the present disclosure.
FIG. 3 shows electric-field intensity simulation data for the nano-antenna of the present disclosure.
FIG. 4 is FDTD simulation data showing field intensity and wavelength versus the diameter of the metal nanoparticle when the nanogap of the nano-antenna of the present disclosure is 6 nm.
FIG. 5 is FDTD simulation data showing field intensity and wavelength versus nanogap spacing when the diameter of the metal nanoparticle of the nano-antenna of the present disclosure is 90 nm.
FIG. 6 is simulation data showing antenna efficiency versus wavelength of the nano-antenna of the present disclosure.
FIG. 7 is a graph comparing emission intensity when a quantum dot is in the nanogap and when the quantum dot is on a SiO₂ layer.
FIG. 8 is a graph comparing emission lifetime when a quantum dot is in the nanogap and when the quantum dot is on a SiO₂ layer.
FIG. 9 is a diagram illustrating various types of emitters.
FIG. 10 is a diagram illustrating various shapes of emitters.
FIG. 11 is a diagram illustrating various shapes of metal nanoparticles.
FIG. 12 is a diagram illustrating a nano-antenna according to a first example of the present disclosure.
FIG. 13 is a diagram illustrating a nano-antenna according to a second example of the present disclosure.
FIG. 14 is a diagram illustrating a nano-antenna according to a third example of the present disclosure.
FIG. 15 is a diagram illustrating a nano-antenna according to another example of the present disclosure.
FIG. 16 is a diagram illustrating a nano-antenna according to yet another example of the present disclosure.

### Best mode for Carrying out the Invention

Hereinafter, the present invention will be described with reference to the accompanying drawings.

First, the present invention relates to a single photon light source applicable to quantum cryptography communication and aims to provide an on-demand single photon light source having excellent practical performance. More specifically, an object of the present invention is to realize a single photon light source that generates single photons at room temperature with high purity, high brightness, and a high repetition rate.

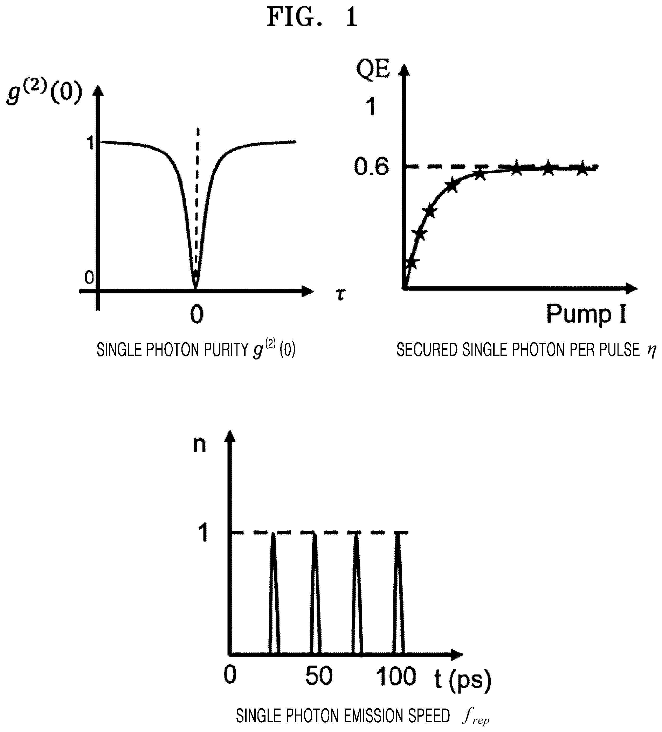

FIG. 1 is a diagram for explaining target performance of the single photon light source of the present invention. An ideal single photon light source satisfies four conditions described above, namely, operability at room temperature, high purity, high brightness, and a high repetition rate. Brightness refers to the probability, per required excitation pulse, that a usable single photon is collected. The target performance of the present invention may be, for example, to satisfy [g^(2)(0) < 0.05, η > 50%, Rate > 40 GHz].

To this end, the present invention secures a plasmonic nano-antenna having maximized Purcell enhancement and antenna efficiency, secures an appropriate single emitter, and fixes the single emitter at a desired position of the nano-antenna to implement a single-photon source.

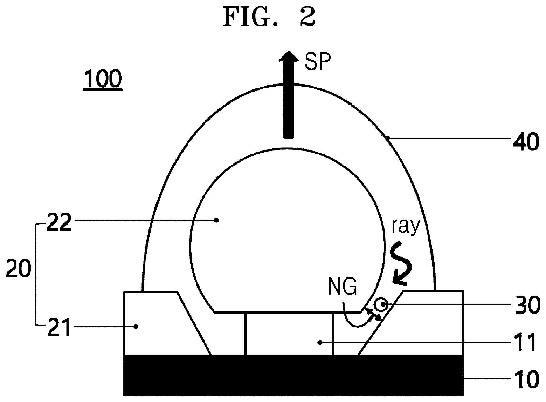

FIG. 2 is a diagram illustrating a single photon light source according to an example of the present invention. The single photon light source 100 of the present invention includes, in large part, a nano-antenna 20 and a single emitter 30.

The nano-antenna 20 is a plasmonic nano-antenna device including a metal layer 21 formed on a substrate 10 and a metal nanoparticle 22 disposed to be spaced apart from the metal layer 21, thereby forming a nanogap NG between the metal nanoparticle 22 and the metal layer 21. The substrate 10 serves as a support and may be a semiconductor or a ceramic.

The metal layer 21 and the metal nanoparticle 22 of the nano-antenna 20 are configured to generate surface plasmons and may include gold, platinum, silver, palladium, aluminum, copper, or a mixture or alloy thereof. The metal layer 21 and the metal nanoparticle 22 may be made of the same metal or different metals.

The nanogap NG is formed between the metal nanoparticle 22 and the metal layer 21 as the metal nanoparticle 22 is spaced apart from the metal layer 21. The spacing of the nanogap NG may be formed to be about 10 nm.

The single emitter 30 is positioned between the metal nanoparticle 22 and the metal layer 21, that is, in the nanogap NG. The single emitter 30 may be a semiconductor nanocrystal having a size of several to several tens of nanometers, in which discrete energy levels and a bandgap exist, so that light of a specific wavelength may be emitted according to the characteristics of the crystal. The single emitter 30 may be a single quantum dot (QD). The diameter of the emitter 30 may be about 10 nm so that it can be positioned and fixed in the nanogap NG.

Accurately positioning an emitter at a location where Purcell enhancement in the nanogap is high is important to improve the performance of the single-photon source. To this end, an optical tweezer method or a suction method may be used to position the emitter, e.g., a quantum dot, in the nanogap where the electric field is strongest. In this case, it is preferable that the single quantum dot be aligned in the dipole direction that provides the largest Purcell enhancement.

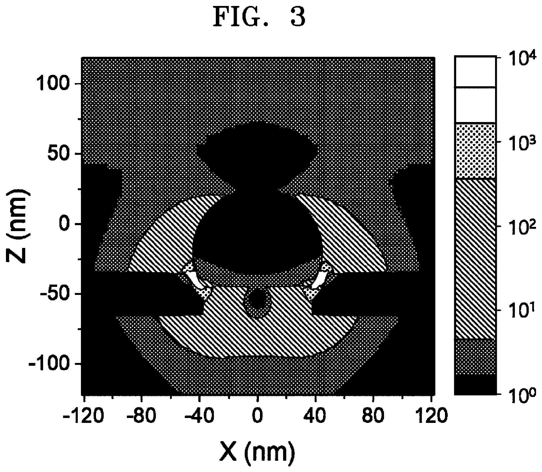

In the nanogap between the metal nanoparticle and the metal layer of the nano-antenna, a strong local electric field is formed and localized surface plasmon resonance (LSPR) occurs. When light (ray), for example a laser, is irradiated onto the emitter located in the nanogap, the emitter is excited to generate a single photon (SP), and the generated single photon (SP) is emitted to the outside through the plasmonic nano-antenna. FIG. 3 shows electric-field simulation data of the nano-antenna of the present invention.

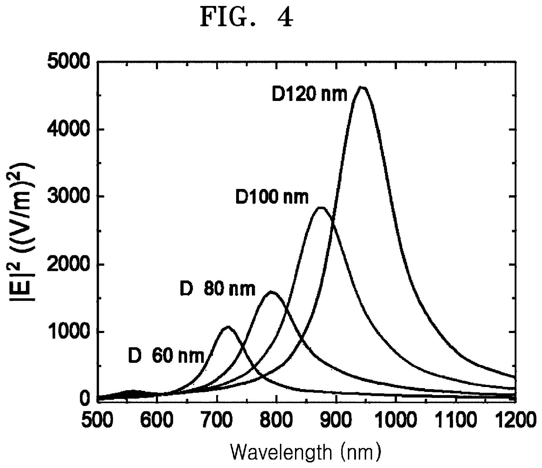

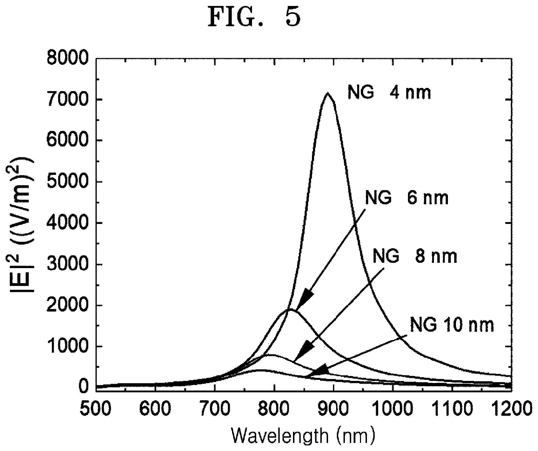

LSPR may be controlled by adjusting the spacing between the metal nanoparticle and the metal layer, i.e., the nanogap, and LSPR may also be controlled by adjusting the size of the metal nanoparticle (for example, the diameter or width of the metal nanoparticle). More specifically, as the nanogap decreases, the field becomes stronger and the LSPR wavelength increases, and as the size of the metal nanoparticle increases, the LSPR wavelength increases. FIG. 4 shows FDTD simulation data of field intensity and wavelength versus the diameter of the metal nanoparticle when the nanogap is 6 nm, and FIG. 5 shows FDTD simulation data of field intensity and wavelength versus nanogap spacing when the diameter of the metal nanoparticle is 90 nm.

Based on the above, by controlling LSPR through the size of the metal nanoparticle and the spacing of the nanogap, the electric field generated at a resonance wavelength may be increased and Purcell enhancement may be increased. Further, by matching the emission wavelength to the LSPR wavelength, the emission rate of the emitter may be further increased. That is, by adjusting the size of the metal nanoparticle and the spacing of the nanogap so that the electric-field intensity is maximized at a desired wavelength, the degree of Purcell enhancement may be controlled. When Purcell enhancement is increased, the radiative recombination rate of an emitter (e.g., a quantum-dot exciton) increases, so that the single-photon repetition rate can be greatly increased, and indistinguishability can also be greatly improved. In addition, even when the intrinsic emission quantum efficiency of the emitter is low, a large Purcell enhancement can increase the emission efficiency to nearly 100% and minimize blinking.

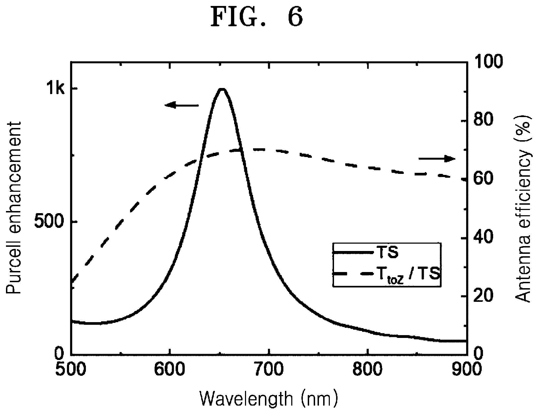

FIG. 6 shows simulation data of antenna efficiency versus wavelength of the nano-antenna of the present invention. In general, most surface-plasmon devices have limitations in performance due to large ohmic loss; however, the present invention uses an efficient antenna structure so that surface plasmons are emitted as light before being lost, thereby achieving high emission efficiency and greatly increasing brightness.

More specifically, in the present invention, the metal nanoparticle is disposed at the center and spaced apart from the metal layer, and thus functions as an optical antenna, thereby increasing emission efficiency and forming a narrow far-field radiation angle, which greatly increases the collection efficiency, i.e., brightness, of single photons. As such, according to the present invention, the antenna quantum efficiency for converting plasmons to light can be maximized.

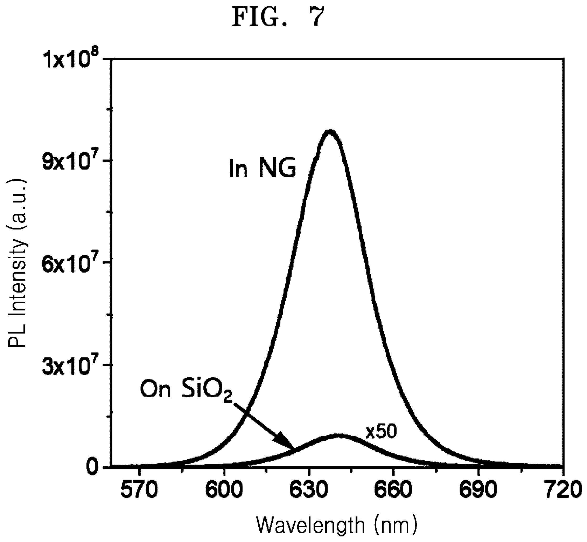

FIG. 7 is a graph comparing emission intensity when a quantum dot is in the nanogap and when the quantum dot is on a SiO₂ layer. The SiO₂ layer may be positioned on a silicon substrate. In FIG. 7, when the quantum dot is on the silicon oxide layer, the emission intensity is so weak that the intensity is shown after being multiplied by 50. As shown, it can be confirmed that the emission intensity of single photons is significantly increased when the quantum dot is in the nanogap compared to when it is not.

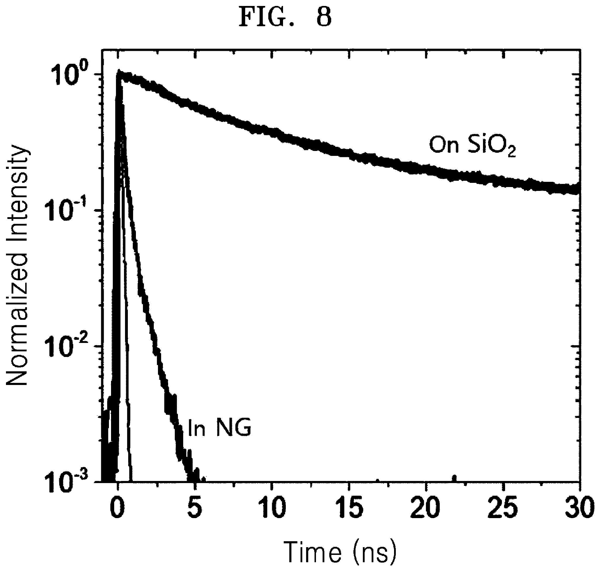

FIG. 8 is a graph comparing emission lifetime when a quantum dot is in the nanogap and when the quantum dot is on a SiO2 layer. As shown, when a quantum dot is placed in the nanogap, the emission lifetime is greatly reduced due to electric-field enhancement, i.e., the emission rate is greatly increased. This is advantageous for improving the repetition rate of the single photon light source at room temperature.

The present invention enhances single-photon generation using Purcell enhancement and, unlike conventional single-photon sources that require a cavity structure, does not require a resonator. In addition, as a result, the emitted single photons are in a linearly polarized state, which provides an advantage in that the laser can be easily filtered out from the single photons.

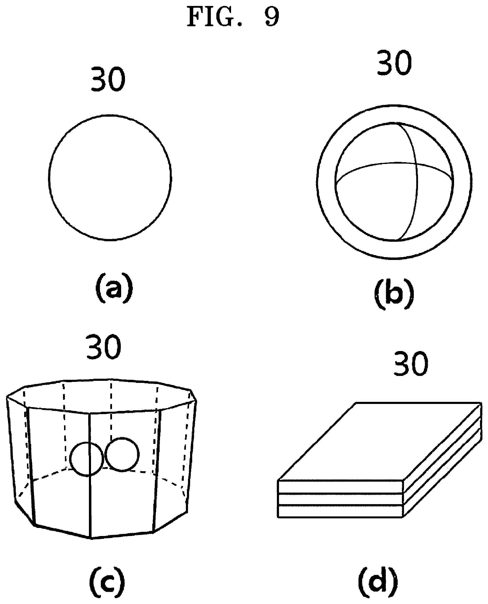

FIG. 9 illustrates various types of emitters. The emitter 30 of the present invention may be a single colloidal quantum dot as shown in (a) of FIG. 9, a core/shell quantum dot as shown in (b) of FIG. 9, a diamond NV center as shown in (c) of FIG. 9, or a nanoplatelet as shown in (d) of FIG. 9.

As shown in (a) of FIG. 9, the emitter 30 may be a colloidal quantum dot, and the colloidal quantum dot may be, for example, a CdSe single colloid.

As shown in (b) of FIG. 9, the emitter 30 may be a core/shell quantum dot, and more specifically may be a colloidal single quantum dot including a core portion and a shell (cladding) portion made of inorganic materials. Due to a quantum confinement effect, discrete energy levels of a colloidal quantum dot vary depending on size.

Such colloidal quantum dots can emit light at room temperature, thereby enabling single photons to be obtained at room temperature, and can also provide high purity. Colloidal quantum dots generally have a broad linewidth at room temperature but may have a narrow linewidth at low temperature. In the present invention, a quantum dot having a narrow linewidth can be used by adjusting the cladding thickness of a core/shell quantum dot and improving surface treatment. More specifically, through a combination of surface treatment and cladding, the present invention can increase electro-hole overlap (rather than relying on non-radiative efficiency), thereby shortening exciton lifetime, and thus can use quantum dots with high emission efficiency, no blinking, and improved performance. For example, a single CdSe quantum dot or a core/shell quantum dot such as CdSe/ZnS may be used as the emitter, and various other quantum dots such as InAs quantum dots, PbS quantum dots, and perovskite quantum dots may also be used.

As shown in (c) of FIG. 9, the emitter may be a diamond defect structure. More specifically, as the emitter, a nanodiamond N-V center having a size of about 10 nm, a nanodiamond Si-V center, or a nanodiamond Sn-V center may be used.

In addition, the emitter may be a silicon defect structure. More specifically, as the emitter, a silicon G center, a silicon W center, and the like may be used.

In addition, the emitter may be a defect structure of a two-dimensional semiconductor. More specifically, defect centers of a transition metal dichalcogenide (TMDC), various defect centers of BN, and the like, in a platelet form sized to fit into the nanogap, may be used.

In addition, as shown in (d) of FIG. 9, the emitter may have a nanoplatelet structure. More specifically, a CdSe nanoplatelet and the like may be used as the emitter.

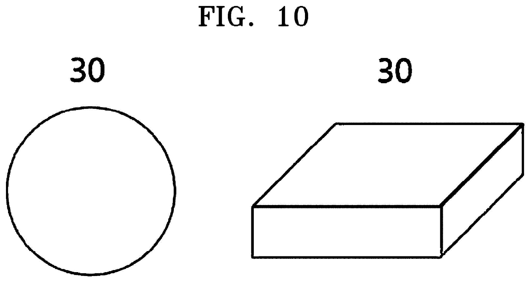

FIG. 10 illustrates various shapes of an emitter. The emitter 30 may be spherical as shown on the left of FIG. 10, or may be plate-shaped as shown on the right of FIG. 10. As described above, the diameter or width of the emitter may be equal to or smaller than the spacing between the metal nanoparticle and the metal layer, i.e., the spacing of the nanogap, so that the emitter can be positioned and fixed at a point in the nanogap.

Referring again to FIG. 2, the metal nanoparticle 22 may be spherical. More specifically, the metal nanoparticle may have a truncated spherical shape and may be seated on a support portion 11 described below. Because such a spherical shape is symmetric in all directions about its center, the nanogap size formed around the sphere can be substantially uniform. Accordingly, the electric field can be uniformly formed over the entire region of the nanogap, and thus substantially uniform performance can be obtained regardless of where the emitter is positioned in the nanogap.

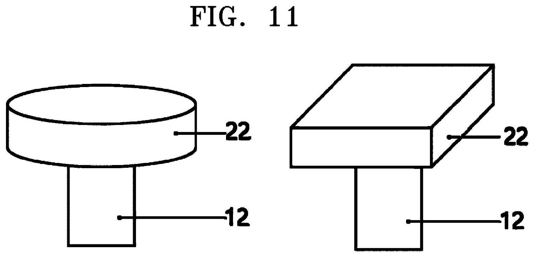

The metal nanoparticle may have various shapes other than a sphere. FIG. 11 illustrates various shapes of a metal nanoparticle. As shown, the metal nanoparticle 22 may have a cylindrical or prismatic shape, and may also have a polyhedral shape.

Referring again to FIG. 2, the single photon light source 100 of the present invention may further include a lens 40. The lens 40 may be, for example, a solid immersion lens, and may be configured to surround the metal nanoparticle 22 as a whole. The lens 40 may be made of a low-refractive-index polymer material or a dielectric such as SiO2. The lens 40 may have a structure whose interior is filled with a polymer, and accordingly a polymer may be interposed in a space between the nanogap NG (or the emitter 30) and the metal nanoparticle 22. That is, the space of the nanogap may be filled with a polymer instead of air.

The lens 40 may be formed in a substantially hemispherical dome or parabolic-lens shape as shown, so as to collect, in a vertically upward direction, single photons generated by the emitter 30 and emitted through the metal nanoparticle 22. Accordingly, the far-field radiation angle of single photons can be further narrowed to increase collection efficiency. In addition, because the lens 40 is provided, the structures therein, that is, the metal nano-particle 22 and the emitter 30, etc. may be protected.

Hereinafter, structures of nano-antennas and single-photon sources based thereon according to various embodiments of the present invention will be described in more detail.

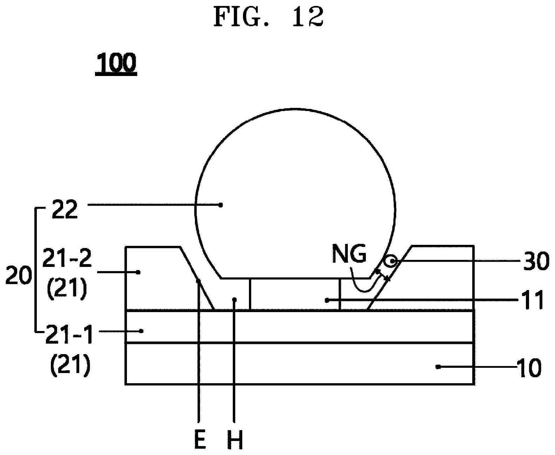

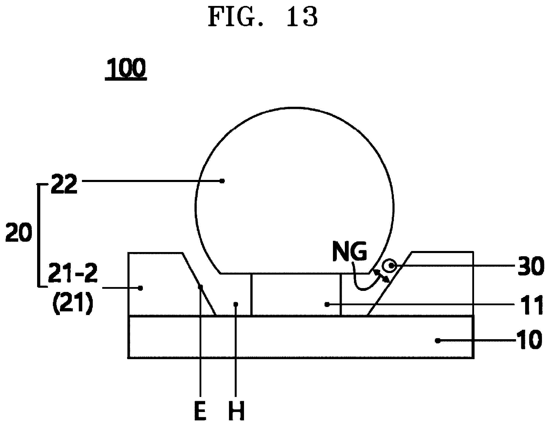

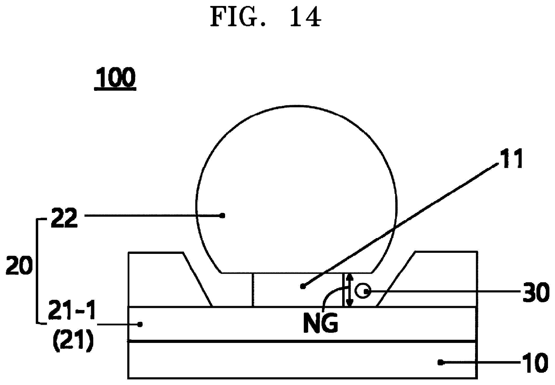

FIG. 12 is a diagram illustrating a nano-antenna according to a first example of the present invention, FIG. 13 is a diagram illustrating a nano-antenna according to a second example of the present invention, and FIG. 14 is a diagram illustrating a nano-antenna according to a third example of the present invention. The nano-antenna of FIG. 13 is the same as the nano-antenna of FIG. 2; however, for convenience of explanation, it will be described as the second example.

First, the nano-antenna according to the first example will be described. As shown in FIG. 12, the nano-antenna 20 of this example includes, as the metal layer 21, a first metal layer 21-1 and a second metal layer 21-2. The first metal layer 21-1 is formed flat on the substrate 10, and the second metal layer 21-2 is formed on the first metal layer 21-1 and may have a hole H at its center. The first metal layer 21-1 and the second metal layer 21-2 may be made of the same or different surface-plasmon metals.

The first metal layer 21-1 is disposed on the bottom with respect to the metal nanoparticle 22, and the second metal layer 21-2 may be disposed on a side surface or a lower side surface with respect to the metal nanoparticle 22. The naming of the first and second metal layers 21-1 and 21-2 according to such shapes/arrangements will be applied in the same manner to the metal layers in the second and third examples.

In this example, the nano-antenna 20 has a structure in which the first metal layer 21-1 is formed on the substrate 10, the second metal layer 21-2 having a hole H at its center is formed on the first metal layer 21-1, and the metal nanoparticle 22 is disposed above the first metal layer 21-1 and inside the hole H of the second metal layer 21-2.

The metal nanoparticle 22 is disposed above the first metal layer 21-1 while being spaced apart from the first metal layer 21-1. To this end, the nano-antenna 20 may further include a support portion 11 supporting the metal nanoparticle 22, and the metal nanoparticle 22 may be seated on the support portion 11. The support portion 11 may be formed by depositing silicon oxide on the first metal layer 21-1 to a predetermined thickness, forming the metal nanoparticle 22, and then removing the silicon oxide except for the portion corresponding to the support portion 11 by wet etching.

In the nano-antenna 20 having such a structure, a nanogap NG is formed between the metal nanoparticle 22 and an inner wall surface E of the hole H of the second metal layer 21-2, and the emitter 30 is positioned in the nanogap NG. The metal nanoparticle 22 is located at the center of the hole H of the second metal layer 21-2 and is spaced apart from the inner wall surface E of the hole H. Accordingly, the nanogap NG is formed in a closed loop along the circumference of a side surface of the metal nanoparticle 22, and the emitter 30 may be positioned at a point of the nanogap NG formed in the closed loop. One side of the emitter 30 may contact the metal nanoparticle 22 and the other side may contact the second metal layer 21-2.

The nanogap NG may be configured such that at least a partial region becomes narrower from an upper side toward a lower side. This can be implemented by adjusting the shape of the metal nanoparticle 22, the shape of the second metal layer 21-2, and the distance between them. By configuring a portion of the nanogap NG to be narrower in this manner, an emitter 30 having a size similar to the spacing of the nanogap NG can be caught and fixed at a central portion of the nanogap NG, which can be helpful for positioning an emitter 30 of a very small scale in the nanogap NG.

Next, the nano-antenna according to the second example will be described. As shown in FIG. 13, the nano-antenna 20 of this example includes, as the metal layer 21, the second metal layer 21-2. The second metal layer 21-2 is formed on the substrate 10 and may have a hole H at its center. The second metal layer 21-2 may be disposed on a side surface or a lower side surface with respect to the metal nanoparticle 22.

In this example, the nano-antenna 20 has a structure in which the second metal layer 21-2 having a hole H at its center is formed on the substrate 10, and the metal nanoparticle 22 is disposed above the substrate 10 and inside the hole H of the second metal layer 21-2.

The metal nanoparticle 22 is disposed above the substrate 10 while being spaced apart from the substrate 10. To this end, the nano-antenna 20 may further include a support portion 11 supporting the metal nanoparticle 22, and the metal nanoparticle 22 may be seated on the support portion 11. The support portion 11 may be formed by depositing silicon oxide to a predetermined thickness, forming the metal nanoparticle 22, and then removing the silicon oxide except for the portion corresponding to the support portion 11 by wet etching.

In the nano-antenna 20 having such a structure, a nanogap NG is formed between the metal nanoparticle 22 and the inner wall surface E of the hole H of the second metal layer 21-2, and the emitter 30 is positioned in the nanogap NG. The metal nanoparticle 22 is located at the center of the hole H of the second metal layer 21-2 and is spaced apart from the inner wall surface E of the hole H. Accordingly, the nanogap NG is formed in a closed loop along the circumference of a side surface of the metal nanoparticle 22, and the emitter 30 may be positioned at a point of the nanogap NG formed in the closed loop. One side of the emitter 30 may contact the metal nanoparticle 22 and the other side may contact the second metal layer 21-2.

The nanogap NG may be configured such that at least a partial region becomes narrower from an upper side toward a lower side. As described above, this can be implemented by adjusting the shape of the metal nanoparticle 22, the shape of the second metal layer 21-2, and the distance between them. By configuring a portion of the nanogap NG to be narrower in this manner, an emitter 30 having a size similar to the spacing of the nanogap NG can be caught and fixed at a central portion of the nanogap NG, which can be helpful for positioning an emitter 30 of a very small scale in the nanogap NG.

Next, the nano-antenna according to the third example will be described. As shown in FIG. 14, the nano-antenna 20 of this example includes, as the metal layer 21, the first metal layer 21-1. The first metal layer 21-1 is formed flat on the substrate 10 and may be disposed on the bottom with respect to the metal nanoparticle 22.

In this example, the nano-antenna 20 has a structure in which the first metal layer 21-1 is formed on the substrate 10 and the metal nanoparticle 22 is disposed above the first metal layer 21-1.

The metal nanoparticle 22 is disposed above the first metal layer 21-1 while being spaced apart from the first metal layer 21-1. To this end, the nano-antenna 20 may further include a support portion 11 supporting the metal nanoparticle 22, and the metal nanoparticle 22 may be seated on the support portion 11. The support portion 11 may be formed integrally with the substrate 10 and may have a structure protruding upward from the substrate 10, and may be formed by etching the substrate 10.

In the nano-antenna 20 having such a structure, a nanogap NG is formed between the metal nanoparticle 22 and an upper surface of the first metal layer 21-1, and the emitter 30 is positioned in the nanogap NG. The metal nanoparticle 22 is spaced apart from the upper surface of the first metal layer 21-1. Accordingly, the nanogap NG is formed in a closed loop along the circumference of a lower portion of the metal nanoparticle 22, and the emitter 30 may be positioned at a point of the nanogap NG formed in the closed loop. One side of the emitter 30 may contact the metal nanoparticle 22 and the other side may contact the first metal layer 21-1.

In this example, the nanogap NG may be configured such that at least a partial region becomes narrower from an outer side toward an inner side. This can be implemented by adjusting the shape of the metal nanoparticle 22, the thickness of the first metal layer, and the distance between them. By configuring a portion of the nanogap NG to be narrower in this manner, an emitter 30 having a size similar to the spacing of the nanogap NG can be caught and fixed at a central portion of the nanogap NG, which can be helpful for positioning an emitter 30 of a very small scale in the nanogap NG.

In summary, the nano-antenna 20 of the first example includes, as the metal layer 21, both the first metal layer 21-1 formed on the bottom of the metal nanoparticle 22 and the second metal layer 21-2 formed on the side of the metal nanoparticle 22; the nano-antenna 20 of the second example includes only the second metal layer 21-2 formed on the side of the metal nanoparticle 22; and the nano-antenna 20 of the third example includes only the first metal layer 21-1 formed on the bottom of the metal nanoparticle 22. The first example is advantageous in that the radiation angle of single photons emitted from the metal nanoparticle 22 is formed to be narrower than in the second and third examples, and the second and third examples are advantageous in that their structures are simpler and manufacturing cost is lower than in the first example.

Although not separately illustrated, in the nano-antennas of FIGS. 12 to 14, the metal nanoparticle 22 may be formed in a columnar or polyhedral shape in addition to a spherical shape, the single emitter 30 may be applied in a spherical or plate shape, and the lens 40 surrounding the metal nanoparticle 22 may also be additionally provided.

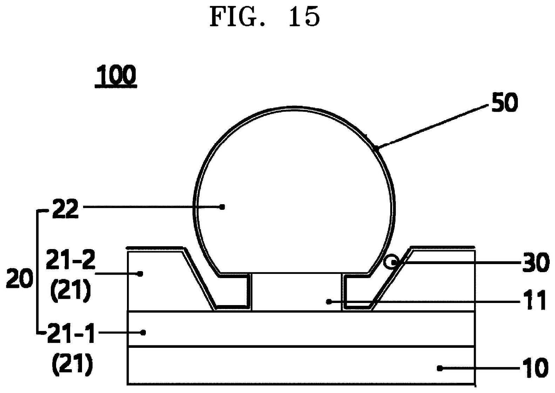

FIG. 15 is a diagram illustrating a nano-antenna according to another example of the present invention. As shown, this example may further include a coating layer 50. The coating layer 50 may be configured to entirely cover the surface of the nano-antenna 20, i.e., the surfaces of the metal layer 21 and the metal nanoparticle 22. The coating layer 50 may be an insulating material, such as an inorganic material such as Al₂O₃ or HfO or an organic material such as PVA. The thickness of the coating layer 50 may be about 2 nm. The coating layer 50 can prevent the emitter 30 from directly contacting the metal nanoparticle 22 or the metal layer 21, and by adjusting the thickness of the coating layer 50 to reduce the spacing of the nanogap NG, the emitter 30 can be more easily fixed in the nanogap NG. Although not separately illustrated, such a coating layer may be equally applied to various nano-antenna examples, and the lens 40 may also be applied together with the coating layer 50.

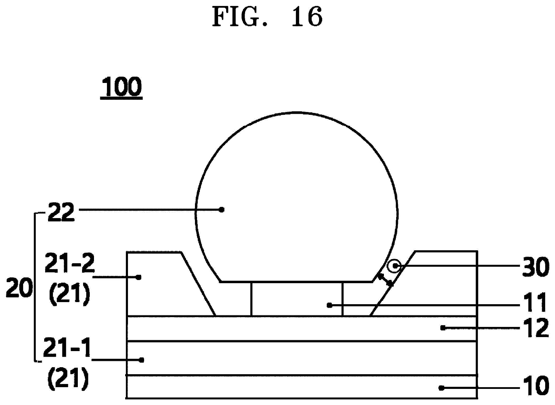

FIG. 16 is a diagram illustrating a nano-antenna according to yet another example of the present invention. As shown, this example may further include an insulating layer 12. The insulating layer 12 may be made of silicon oxide (SiO2). This can be implemented, during a nano-antenna fabrication process, by etching only a portion of the support portion 11 such that SiO2 remains also in regions other than below the support portion 11.

The single photon light source of the present invention has a simple structure so that it is easy to manufacture and inexpensive to manufacture. By emitting single photons vertically upward through the optical antenna structure of the nano-antenna, it has excellent collection efficiency. In addition, various types of single-photon generation are possible by applying various emitters to the nano-antenna. Further, since the bandwidth is wide, production yield is high, and operation at room temperature and at various wavelengths is possible.

Although embodiments of the present invention have been described above with reference to the accompanying drawings, those skilled in the art will understand that the present invention may be embodied in other specific forms without changing the technical spirit or essential features thereof. Therefore, the embodiments described above should be understood in all respects as illustrative and not restrictive.

## Claims

1. A single photon light source comprising:
a nano-antenna including a metal layer formed on a substrate and a metal nanoparticle disposed to be spaced apart from the metal layer; and
a single emitter positioned in a nanogap between the metal nanoparticle and the metal layer,
wherein the single photon light source is configured such that light is irradiated onto the emitter to generate a single photon and the generated single photon is emitted through the nano-antenna.

2. The single photon light source of claim 1, wherein
Purcell enhancement is controllable by adjusting at least one of a size of the metal nanoparticle and a spacing of the nanogap.

3. The single photon light source of claim 1, wherein
the emitter is excited and a linear polarized single photon is generated.

4. The single photon light source of claim 1, wherein
a size of the emitter is equal to or smaller than the spacing of the nanogap.

5. The single photon light source of claim 1, wherein
the nano-antenna has a structure in which:
a first metal layer is formed on the substrate,
a second metal layer having a hole at a center thereof is formed on the first metal layer, and
the metal nanoparticle is disposed above the first metal layer and
inside the hole of the second metal layer, and
wherein the emitter is positioned in a nanogap between the metal nanoparticle and an inner wall surface of the hole of the second metal layer.

6. The single photon light source of claim 1, wherein
wherein the nano-antenna has a structure in which:
a second metal layer having a hole at a center thereof is formed on the substrate; and
the metal nanoparticle is disposed above the substrate and inside the hole of the second metal layer, and
wherein the emitter is positioned in a nanogap between the metal nanoparticle and an inner wall surface of the hole of the second metal layer.

7. The single photon light source of claim 1, wherein
the nano-antenna has a structure in which:
a first metal layer is formed on the substrate; and
the metal nanoparticle is disposed above the first metal layer, and
wherein the emitter is positioned in a nanogap between the metal nanoparticle and an upper surface of the first metal layer.

8. The single photon light source of claim 1, wherein
a spacing of the nanogap is configured to become narrower from an upper side toward a lower side, or to become narrower from an outer side toward an inner side.

9. The single photon light source of claim 1, wherein
the emitter has a spherical shape.

10. The single photon light source of claim 1, wherein
the emitter has a plate shape.

11. The single photon light source of claim 1, wherein
the emitter comprises a single colloidal quantum dot, a core/shell quantum dot, a diamond defect structure, a silicon defect structure, a two-dimensional semiconductor defect structure, or a nanoplatelet structure.

12. The single photon light source of claim 1, wherein
the metal nano-particle has a spherical shape.

13. The single photon light source of claim 1, wherein
the metal nano-particle has a cut spherical shape.

14. The single photon light source of claim 1, wherein
the metal nanoparticle is in the shape of a cylinder or polyhedron.

15. The single photon light source of claim 1, further comprising
a support portion supporting the metal nanoparticle, wherein the metal nanoparticle is seated on the support portion.

16. The single photon light source of claim 1, further comprising
a lens surrounding the metal nanoparticle, wherein the lens directs single photons emitted from the metal nanoparticle in a vertically upward direction.

17. The single photon light source of claim 1, wherein
a coating layer is formed on at least a portion of a surface of the nano-antenna.

18. The single photon light source of claim 1, wherein
the nano-antenna has a structure in which:
a first metal layer is formed on the substrate;
an insulating layer is formed on the first metal layer;
a second metal layer having a hole at a center thereof is formed on the insulating layer; and
the metal nanoparticle is disposed above the insulating layer and inside the hole of the second metal layer, and
wherein the emitter is positioned in a nanogap between the metal nanoparticle and an inner wall surface of the hole of the second metal layer.
